# FASCICULE DE BREVET EUROPEEN

(11) **EP 0 592 281 B1**
(45) Date de publication et mention de la délivrance du brevet: **01.04.1998**
(21) Numéro de dépôt: 93402369.8
(22) Date de dépôt: 28.09.1993
(51) Int. Cl.: H03F 3/60, H03F 3/24

(54) **Amplificateur de puissance large bande haute fréquence**
Breitbandiger Hochfrequenzleistungsverstärker
Wideband high frequency power amplifier

(30) Priorité: 09.10.1992 FR 9212031
(43) Date de publication de la demande: 13.04.1994
(73) Titulaire: THOMCAST, 78700 Conflans-Sainte-Honorine (FR)
(72) Inventeur: Michel, Jean, F-92402 Courbevoie Cédex (FR); Combe, Jean-Claude, F-92402 Courbevoie Cédex (FR); De Faria, Herminio, F-92402 Courbevoie Cédex (FR)
(74) Mandataire: Lincot, Georges

(56) Documents cités:
- DE-B- 2 837 817
- US-A- 3 869 678
- US-A- 4 916 410
- NACHRICHTEN ELEKTRONIK vol. 32, no. 2, Février 1978, HEIDELBERG DE pages 48 - 50 GRAF 'Ein Linear-Leistungsverstärker für Fernsehsender'
- PATENT ABSTRACTS OF JAPAN vol. 13, no. 450 (E-830)11 Octobre 1989 & JP-A-1 174 106 ( NEC CORP. ) 10 Juillet 1989
- SYMPOSIUM RECORD BROADCAST SESSIONS REPORT NO: NC09101 16 Janvier 1991, pages 823 - 852 M. J. KÖPPEN 'High power solid state amplifiers for TV band IV.V transmitters using BLV62 transistor'

## Description

La présente invention telle qu'elle est définie dans les revendications concerne un amplificateur de puissance large bande haute fréquence.

Il est connu qu'un amplificateur de puissance fonctionnant en classe AB, B ou C possède un comportement non linéaire.

Ce comportement non linéaire se traduit notamment par une variation du courant consommé par l'amplificateur en fonction du niveau du signal amplifié. Les sources d'alimentation du collecteur et de la base du ou des transistors bipolaires équipant généralement de tels amplificateurs, sont considérées présenter une impédance nulle vis-à-vis des transistors. Dans le cas contraire, les variations de tension résultantes entraînent une modulation d'amplitude du signal amplifié venant s'ajouter à la modulation d'origine du signal. Ces sources d'alimentation ne sont généralement pas directement appliquées sur la base et le collecteur du ou des transistors de l'étage de puissance mais par l'intermédiaire de bobines de découplage entre le continu et les hautes fréquences appelées également selfs de choc.

Le document Nachrichten Elektronik, vol.32, no. 2, février 1978 Heidelberg, DE, Graf "Ein Linear-Leistungsverstärker für Fernsehsender, p. 48-50, donne un exemple d'amplificateur haute fréquence.

Classiquement un premier type d'amplificateur de puissance haute fréquence se compose essentiellement d'un étage de puissance, comportant un ou plusieurs transistors montés en parallèle, raccordés respectivement à l'entrée et à la sortie du circuit de l'amplificateur par l'intermédiaire d'un circuit d'adaptation d'impédance, ou transformateur d'impédance. Les transformateurs d'impédance d'entrée et de sortie adaptent respectivement les impédances présentées par la base et le collecteur du transistor à l'impédance du circuit haute fréquence, généralement l'impédance caractéristique du circuit Z_{c} = 50 Ohms. Les tensions d'alimentation du transistor sont appliquées respectivement sur le collecteur et la base de celui-ci par l'intermédiaire d'une bobine, ou self de choc. L'impédance présentée par la self de choc doit être d'une part suffisamment grande devant les impédances d'entrée et de sortie du transistor dans le domaine des fréquences de travail de l'amplificateur, de telle sorte que son effet est négligeable sur le fonctionnement haute fréquence de l'amplificateur et, d'autre part, aussi faible que possible dans la bande de base vidéofréquence du signal à transmettre, de l'ordre de O à 10 MHz pour un signal de télévision. De ce fait la tension développée entre les extrémités de chaque bobine est réduite au maximum et permet par conséquent d'éviter une modulation supplémentaire sur les tensions de polarisation pouvant provoquer une distorsion du signal à amplifier. Un des inconvénients de ce montage, est la difficulté d'arriver à un compromis satisfaisant pour la détermination de la valeur de cette impédance.

Un deuxième type de montage s'apparentant au montage précédent, de structure symétrique utilise deux transistors, ou transistor double, et permet de faciliter l'adaptation d'impédance entre le circuit extérieur d'impédance caractéristique 50 Ω et les impédances présentées par l'étage amplificateur.

Les tensions de polarisation continue des transistors sont appliquées respectivement sur la base et le collecteur de chaque transistor par l'intermédiaire d'une self de choc et sont donc toujours soumises aux impératifs du montage précédent.

Dans un troisième montage d'amplificateur de type connu, des transformateurs de symétrie entrée/sortie sont utilisés pour amener les tensions de polarisation respectivement sur la base et le collecteur de chaque transistor du transistor double. Ce dernier montage permet d'obtenir un point "froid" pour le signal haute fréquence, c'est-à-dire découplé vis-à-vis des hautes fréquences, sur lequel est appliqué la source de tension respective à la base et au collecteur de chaque transistor, et permet ainsi d'échapper au compromis précédent.

Dans ce montage, le transistor double est considéré fonctionner comme un amplificateur différentiel. Une liaison continue est également assurée entre le point d'application de la tension base et la base de chaque transistor, le transformateur d'impédance d'entrée étant supposé présenter une liaison continue entre ses bornes d'entrée et ses bornes de sortie. Le circuit collecteur est déduit du circuit d'entrée décrit ci-dessus par symétrie par rapport à l'étage amplificateur. Dans ce dernier type d'amplificateur, les tensions d'alimentation de la base et du collecteur de chaque transistor sont appliquées sur des points froids pour les hautes fréquences ce qui permet de s'affranchir des selfs de chocs gênantes dans la bande de base vidéofréquence.

Cependant tous les problèmes ne sont pas résolus par ce dernier montage et de nouveaux inconvénients apparaissent. Ainsi, le transformateur d'impédance présente une liaison continue entre ses bornes d'entrée et de sortie ce qui peut être une contrainte gênante et les impédances présentées par le transformateur de symétrie et le transformateur d'impédance dans la liaison entre le point d'application des tensions base/collecteur du transistor restent élevées dans la bande de base de l'amplificateur.

Le but de la présente invention est de pallier les inconvénients précités.

A cet effet, l'invention a pour objet un amplificateur de puissance large bande haute fréquence, organisé autour d'un circuit de masse servant de potentiel de référence, du type comportant dans l'ordre, de l'entrée vers la sortie, un premier transformateur de symétrie sur l'entrée duquel est injecté un signal E à amplifier, un transformateur d'impédance d'entrée, un étage amplificateur comportant au moins deux transistors montés en étage différentiel, un transformateur d'impédance de sortie et un deuxième transformateur de symétrie délivrant le signal d'entrée amplifié S, caractérisé en ce qu'il comporte, en outre, au moins un tronçon de ligne de transmission haute fréquence, transmettant chaque tension de polarisation respectivement sur la borne d'entrée et de sortie de chaque transistor, présentant en parallèle sur chaque borne une impédance haute fréquence telle que son effet est négligeable vis-à-vis de l'impédance haute fréquence présentée par chaque borne de transistor et présentant une impédance série négligeable dans la bande de base du signal à amplifier E telle que la tension de polarisation appliquée sur l'une des extrémités du tronçon de ligne est transmise quasiment à l'identique sur son autre extrémité connectée sur une borne de transistor, et en ce que chaque tronçon de ligne transmettant respectivement la tension de polarisation d'entrée sur chaque transistor est d'impédance haute fréquence identique et de longueur identique comprise entre la longueur λ/8 et 3λ/8, où λ correspond à la longueur d'onde de la porteuse du signal E à amplifier, et en ce que chaque tronçon de ligne transmettant respectivement la tension de polarisation de sortie sur chaque transistor est d'impédance identique et de longueur identique comprise entre λ/8 et 3λ/8.

L'invention a pour principal avantage de réaliser une connexion basse impédance des sources de tension alimentant l'amplificateur sans préjudice pour le fonctionnement haute fréquence de l'amplificateur tout en obtenant des performances de qualité notamment dans les émissions de signaux de télévision.

D'autres caractéristiques et avantages de l'invention apparaîtront à la lecture de la description qui suit, faite en regard des figures annexées qui représentent :
- les figures 1 à 3, trois schémas électriques d'amplificateur haute fréquence selon l'art antérieur,
- la figure 4, un schéma électrique du circuit d'entrée d'un mode de réalisation d'un amplificateur selon l'invention et,
- la figure 5, un schéma électrique complet du mode de réalisation de la figure 4.

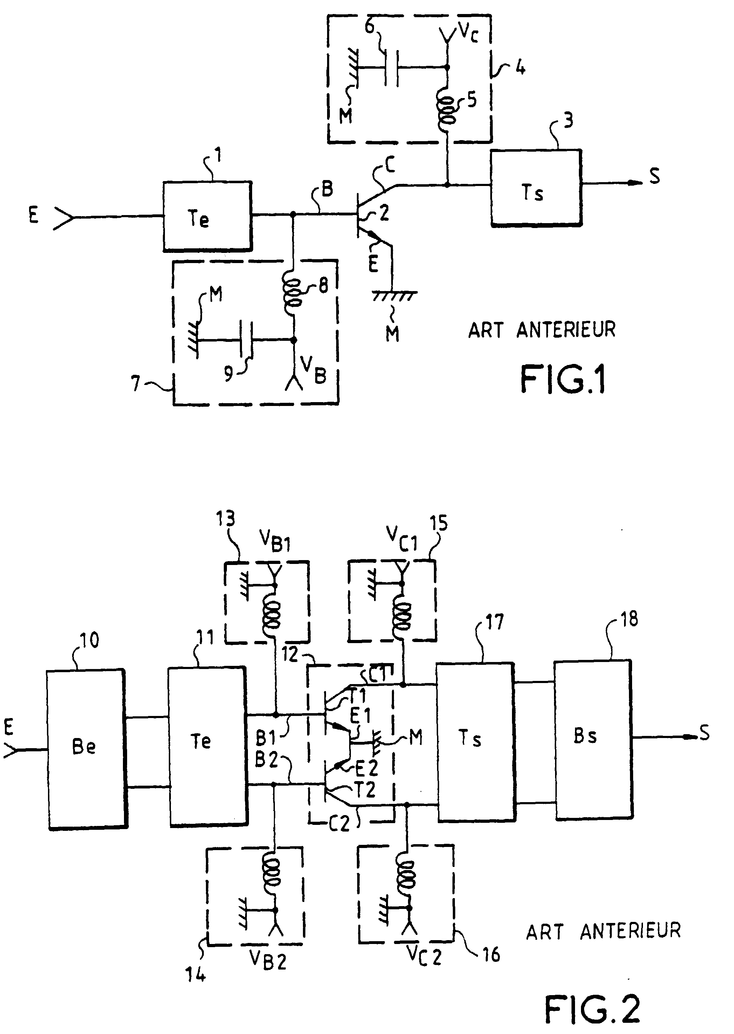

Le schéma électrique de la figure 1 comporte, de l'entrée E vers la sortie S, un transformateur d'impédance 1, Tₑ, recevant sur son entrée E le signal haute fréquence à amplifier et dont la sortie est couplée à la base B d'un transistor bipolaire 2. L'émetteur E du transistor 2 est relié à un potentiel de masse M servant de potentiel de référence et le collecteur C du transistor 2 est couplé sur l'entrée d'un transformateur d'impédance 3,T_{S}, dont la sortie délivre le signal d'entrée E amplifié S. Un circuit de polarisation 4 du collecteur C du transistor 2, délimité par une ligne fermée discontinue, comporte une bobine, ou self de choc, 5 disposée entre le point d'application V_{c} de la tension collecteur et le collecteur C du transistor 2. Le point V_{c} est relié au potentiel de masse M par l'intermédiaire d'un condensateur de découplage 6. De même, un circuit de polarisation 7 de la base B du transistor 2 délimité par une ligne fermée discontinue, comporte une bobine, ou self de choc, 8 disposée entre le point d'application V_{B} de la tension base et la base B du transistor 2. Le point V_{B} est relié au potentiel de masse M par l'intermédiaire d'un condensateur 9.

Le schéma électrique de la figure 2 décrit un mode de réalisation d'un amplificateur à transistor double basé sur le schéma électrique de la figure 1.

Le signal d'entrée E est appliqué sur l'entrée d'un transformateur de symétrie Bₑ, ou balun, 10. Le balun d'entrée 10 est couplé par ses deux sorties à un transformateur d'impédance 11, Tₑ, dont les deux sorties sont couplées respectivement à la base B₁ et B₂ de deux transistors T₁ et T₂ constituant un étage amplificateur 12 représenté à l'intérieur d'une ligne fermée discontinue. Les émetteurs E₁ et E₂ des deux transistors T₁ et T₂ sont reliés au potentiel de masse M. Les circuits de polarisation 13, 14, 15 et 16 sont identiques à ceux décrits dans le précédent schéma électrique et ne sont donc pas redécrits. Ils alimentent respectivement la base B₁ et B₂ et le collecteur C₁ et C₂ de chaque transistor T₁ et T₂. Chaque collecteur C₁ et C₂ est couplé respectivement à une entrée d'un transformateur d'impédance, T_{S}, 17 dont les deux sorties sont couplées à un transformateur de symétrie, B_{S}, 18 délivrant sur sa sortie un signal S correspondant au signal d'entrée E amplifié.

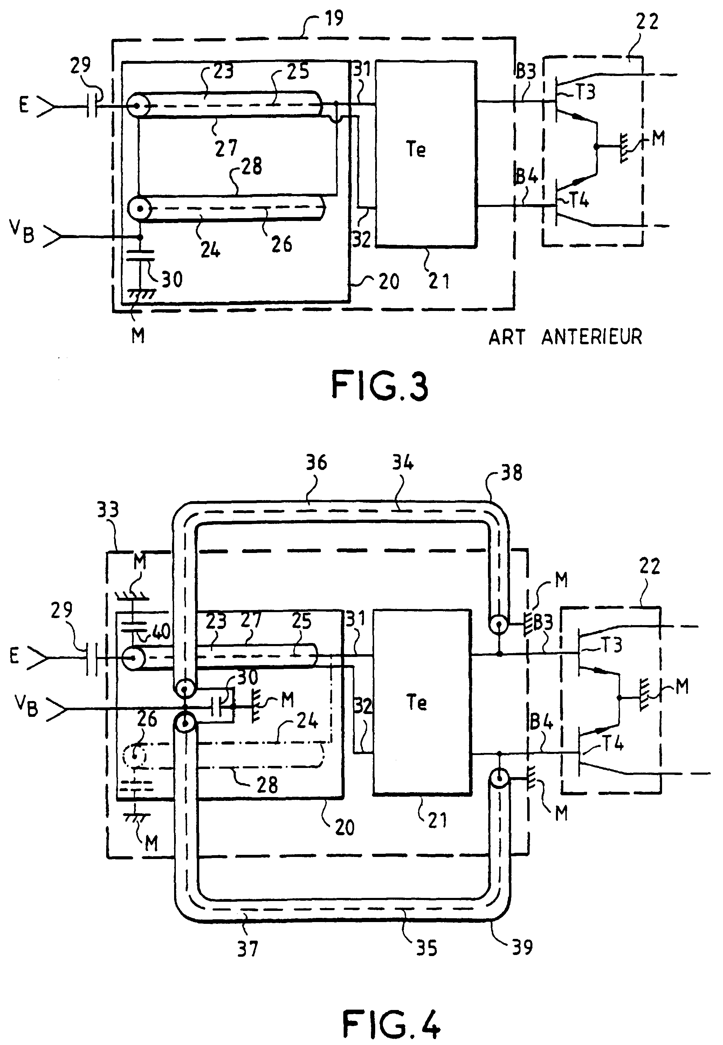

Le schéma électrique de la figure 3 représente un circuit d'entrée 19, délimité par une ligne fermée discontinue, couplé en sortie à un étage amplificateur 22 comportant deux transistors T₃ et T₄, également délimité par une ligne fermée discontinue, du type de la figure précédente. Le circuit 19 comporte en entrée un balun 20 couplé en sortie à un transformateur d'impédance, Tₑ, 21. Sur ce schéma la tension de polarisation base n'est plus appliquée sur la base du transistor par l'intermédiaire d'une self de choc mais appliquée sur une des deux entrées V_{B} du balun 20, l'autre entrée recevant le signal E à amplifier.

Le balun 20 du circuit d'entrée 19 comporte deux tronçons de lignes 23 et 24 de transmission, par exemple coaxiales, mis en parallèle, de longueur identique comprise entre les longueurs d'onde λ/8 et 3λ/8, la grandeur λ correspondant à la longueur d'onde de la porteuse du signal à amplifier, couvrant ainsi la bande passante de l'amplificateur. Chaque tronçon de ligne coaxiale 23 et 24 comporte respectivement un conducteur central 25 et 26 représentés sur la figure par des tronçons de lignes discontinues, et un conducteur extérieur 27 et 28. Le signal d'entrée E est couplé au conducteur central 25 du premier tronçon de ligne 23 par l'intermédiaire d'un condensateur de liaison 29. L'extrémité, côté signal d'entrée E, du conducteur extérieur 27 du premier tronçon 23 est reliée du même côté à l'extrémité du conducteur extérieur 28 du deuxième tronçon 24, elle-même reliée au potentiel de masse M par l'intermédiaire d'un condensateur 30. La tension de polarisation des bases B₃ et B₄ de l'étage amplificateur 22 est appliquée sur le point V_{B} soit sur la borne du condensateur 30 opposée à la borne reliée au potentiel de masse M.

Le conducteur central 25 du tronçon 23 est couplé par son autre extrémité à une, 31, des deux entrées 31 et 32 d'un transformateur d'impédance, Tₑ, 21 et le conducteur extérieur 27 de la même extrémité est couplée à la deuxième entrée 32 de ce même transformateur 21.

Le conducteur central 26 du tronçon 24 n'est pas connecté. Le conducteur extérieur 28 du tronçon 24, en son autre extrémité, est couplé à la première entrée 31 du transformateur, Tₑ, 21. Les deux sorties du transformateur, Tₑ, 21 sont couplées respectivement aux deux bases B₃ et B₄ de l'étage amplificateur 22. Dans ce mode de réalisation, seul le conducteur extérieur 28 du deuxième tronçon 24 est utilisé. Il symétrise les impédances par rapport au potentiel de masse M du balun 20 et permet en outre une liaison continue entre le point d'application V_{B} et les bases B₃ et B₄ des transistors T₃ et T₄, le transformateur, Tₑ, 21 étant supposé présenter une liaison continue entre ses bornes d'entrée et de sortie.

Le circuit collecteur, se déduisant du circuit d'entrée 19 par symétrie par rapport à l'étage amplificateur 22, n'est pas décrit.

Un mode de réalisation d'un amplificateur selon l'invention est partiellement illustré par la figure 4 où les éléments homologues à ceux de la figure 3 sont désignés par les mêmes repères pour un souci de clarté. Dans ce mode de réalisation, le deuxième tronçon 24 du balun d'entrée 20 ainsi que ses connexions sont représentés en traits mixtes. La tension de polarisation commune aux bases B₃ et B₄ de l'étage amplificateur 22, fonctionnant par exemple en classe AB, est appliquée sur le point commun V_{B} des extrémités des conducteurs centraux 34 et 35, représentés par une ligne discontinue, respectifs à deux tronçons de lignes coaxiales 36 et 37 identiques en impédance et en longueur. Elles amènent respectivement la tension d'alimentation des bases B₃ et B₄, appliquée au point V_{B}, jusqu'aux bases effectives B₃ et B₄ du transistor double 22. Le point commun V_{B} est relié au potentiel de masse M par le condensateur 30. Les tronçons de lignes 36 et 37 ont une longueur comprise entre les longueurs d'onde λ/8 et 3λ/8, λ étant la longueur d'onde correspondant à la porteuse du signal. Les conducteurs extérieurs 38 et 39 respectifs aux tronçons de lignes 36 et 37 sont directement reliés au potentiel de masse M en leurs deux extrémités. L'impédance haute fréquence ramenée par les lignes 36 et 37 en parallèle sur les bases B₃ et B₄ de l'étage amplificateur 22 est élevée par rapport aux impédances présentées par les transistors T₃ et T₄ et n'affecte donc pas leur fonctionnement en haute fréquence. L'impédance dans la bande de base vidéofréquence est d'autant plus faible que la ligne coaxiale utilisée est d'impédance faible.

L'étage amplificateur 22 fonctionnant en tant qu'amplificateur différentiel, l'identité parfaite des tronçons de lignes 36 et 37, assure une parfaite réjection en mode commun.

Le circuit d'entrée 33, constitué du balun 20 et du transformateur d'impédance 21, retrouve son indépendance vis-à-vis de la continuité électrique qui était assurée entre les bornes d'entrée et les bornes de sortie du circuit d'entrée 19 du montage de la figure 3. De ce fait le deuxième tronçon de ligne coaxiale 24 du balun 20 n'est plus indispensable pour la transmission du continu et peut être supprimé ou maintenu au gré du concepteur de l'amplificateur. Dans les deux cas un condensateur de découplage 40 est disposé entre le conducteur extérieur 27 de l'extrémité, côté entrée, du tronçon de ligne 23, de même pour le tronçon 24 s'il est utilisé.

L'application de la tension collecteur est effectuée à l'aide d'un circuit symétrique, par rapport à l'étage amplificateur 22, à celui du circuit d'entrée 33 et des tronçons de lignes 36 et 37 et n'est donc pas décrit dans la présente description.

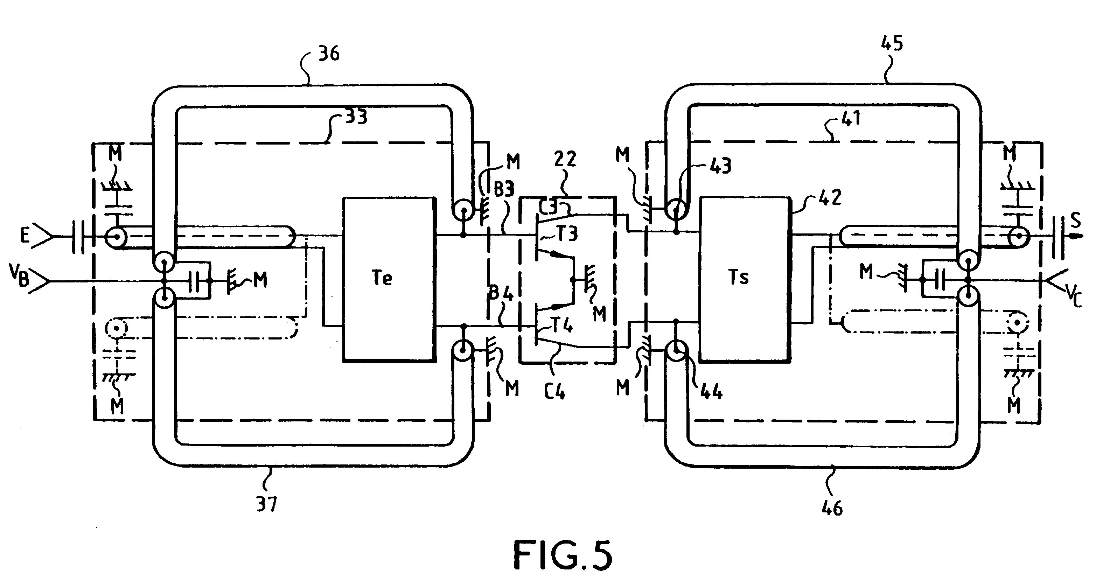

La figure 5, illustre un mode de réalisation complet d'un amplificateur selon l'invention. Sur cette figure, les éléments homologues à ceux des figures précédentes sont désignés par les mêmes repères. Le signal d'entrée E et la tension d'alimentation commune des bases B₃ et B₄ de l'étage amplificateur 22 sont appliqués sur le circuit d'entrée 33. Les deux sorties du circuit 33 sont respectivement couplées aux bases B₃ et B₄ de l'étage amplificateur 22 dont les deux sorties, correspondant respectivement aux collecteurs C₃ et C₄ des transistors T₃ et T₄, sont couplées respectivement aux deux entrées d'un circuit 41 de sortie délimité par une ligne fermée discontinue, symétrique, par rapport à l'étage amplificateur 22, au circuit d'entrée 33 et aux tronçons de lignes 36 et 37. Les deux entrées du circuit de sortie 41 correspondent également respectivement aux deux entrées d'un transformateur d'impédance de sortie, T_{S}, 42 ainsi qu'aux conducteurs centraux 43 et 44 de deux tronçons de lignes 45 et 46 amenant la tension collecteur appliquée au point V_{c} sur chaque collecteur C₃ et C₄ des transistors T₃ et T₄. Ces deux tronçons de lignes, 45 et 46, sont identiques en longueur et en impédance. Leur longueur est comprise entre les longueurs λ/8 et 3λ/8 correspondant à des fractions de la longueur d'onde de la porteuse du signal E à amplifier.

Le signal S du circuit de sortie 41 correspond au signal d'entrée E amplifié.

L'invention n'est pas strictement limitée au mode de réalisation décrit ci-dessus. Notamment, les tronçons de lignes de transmissions utilisés peuvent être réalisés dans une autre technologie généralement utilisée pour la réalisation de circuits haute fréquence, telle que par exemple la technologie des lignes microrubans.

## Revendications

1. Amplificateur de puissance large bande haute fréquence, organisé autour d'un circuit de masse (M) servant de potentiel de référence, du type comportant dans l'ordre, de l'entrée vers la sortie, un premier transformateur de symétrie sur l'entrée duquel est injecté un signal E à amplifier, un transformateur d'impédance d'entrée, un étage amplificateur comportant au moins deux transistors montés en étage différentiel, un transformateur d'impédance de sortie et un deuxième transformateur de symétrie délivrant le signal d'entrée amplifié S, caractérisé en ce qu'il comporte, en outre, au moins un tronçon de ligne de transmission haute fréquence (36, 37, 45, 46), transmettant chaque tension de polarisation respectivement sur la borne d'entrée (B₃, B₄) et de sortie (C₃, C₄) de chaque transistor (T₃, T₄), présentant en parallèle sur chaque borne (B₃, B₄, C₃, C₄) une impédance haute fréquence telle que son effet est négligeable vis-à-vis de l'impédance haute fréquence présentée par chaque borne (B₃, B₄, C₃, C₄) de transistor (T₃, T₄) et présentant une impédance série négligeable dans la bande de base du signal à amplifier E telle que la tension de polarisation appliquée sur l'une des extrémités du tronçon de ligne (36, 37, 45, 46) est transmise quasiment à l'identique sur son autre extrémité connectée sur une borne (B₃, B₄, C₃, C₄) de transistor (T₃, T₄), et en ce que chaque tronçon de ligne (36, 37) transmettant respectivement la tension de polarisation d'entrée sur chaque transistor (T₃, T₄) est d'impédance haute fréquence identique et de longueur identique comprise entre la longueur λ/8 et 3λ/8, où λ correspond à la longueur d'onde de la porteuse du signal E à amplifier, et en ce que chaque tronçon de ligne (45, 46) transmettant respectivement la tension de polarisation de sortie sur chaque transistor (T₃, T₄) est d'impédance identique et de longueur identique comprise entre λ/8 et 3λ/8.

2. Amplificateur selon la revendication 1, caractérisé en ce que chaque tronçon de ligne de transmission haute fréquence (36, 37, 45, 46) est un tronçon de ligne coaxiale tel que le conducteur intérieur du tronçon transmet la tension de polarisation entre ces deux extrémités et tel que le conducteur extérieur du tronçon est couplé en ses deux extrémités au potentiel de référence (M).

3. Amplificateur selon la revendication 1, caractérisé en ce que chaque tronçon de ligne de transmission haute fréquence (36, 37, 45, 46) est un tronçon de ligne microruban tel que le ruban métallique transmet la tension de polarisation entre ses deux extrémités et tel que le plan métallisé opposé au ruban métallique est couplé en ses deux extrémités au potentiel de référence (M).

4. Amplificateur selon l'une quelconque des revendications précédentes, caractérisé en ce que les transistors (T₃, T₄) sont des transistors bipolaires fonctionnant en classe AB.

## Patentansprüche

1. Breitbandiger Hochfrequenzleistungsverstärker, der um einen als Bezugspotential dienenden Massekreis (M) aufgebaut ist, von dem Typ, der der Reihe nach vom Eingang zum Ausgang enthält: einen ersten Symmetrieübertrager, dessen Eingang ein zu verstärkendes Signal E zugeführt wird, einen Eingangs-Impedanzübertrager, eine Verstärkerstufe mit wenigstens zwei als Differenzstufe geschalteten Transistoren, einen Ausgangs-Impedanzübertrager und einen zweiten Symmetrieübertrager, der das verstärkte Eingangssignal S abgibt, dadurch gekennzeichnet, daß er ferner wenigstens einen Hochfrequenzübertragungsleitungsabschnitt (36, 37, 45, 46) enthält, der jede Vorspannung zum Eingangsanschluß (B₃, B₄) bzw. zum Ausgangsanschluß (C₃, C₄) jedes Transistors (T₃, T₄) überträgt, parallel an jedem Anschluß (B₃, B₄, C₃, C₄) eine solche Hochfrequenzimpedanz aufweist, daß ihre Wirkung gegenüber der Hochfrequenzimpedanz vernachlässigbar ist, die jeder Anschluß (B₃, B₄, C₃, C₄) eines Transistors (T₃, T₄) aufweist, und eine vernachlässigbare Serienimpedanz im Grundband des zu verstärkenden Signals E aufweist, so daß die an eines der Enden des Leitungsabschnitts (36, 37, 45, 46) angelegte Vorspannung quasi identisch zu seinem anderen Ende übertragen wird, das mit einem Anschluß (B₃, B₄, C₃, C₄) eines Transistors (T₃, T₄) verbunden ist, und daß jeder Leitungsabschnitt (36, 37), der die Eingangsvorspannung jeweils zu einem der Transistoren (T₃, T₄) überträgt, die gleiche Hochfrequenzimpedanz und die gleiche Länge hat, die zwischen λ/8 und 3λ/8 liegt, wobei λ der Wellenlänge der Trägerfrequenz des zu verstärkenden Signals E entspricht, und daß jeder Leitungsabschnitt (45, 46), der die Ausgangsvorspannung jeweils zu einem der Transistoren (T₃, T₄) überträgt, die gleiche Hochfrequenzimpedanz und die gleiche Länge hat, die zwischen λ/8 und 3λ/8 liegt.

2. Verstärker nach Anspruch 1, dadurch gekennzeichnet, daß jeder Hochfrequenzübertragungsleitungsabschnitt (36, 37, 45, 46) ein Koaxialleitungsabschnitt ist, derart, daß der Innenleiter des Abschnitts die Vorspannung zwischen seinen beiden Enden überträgt und der Außenleiter des Abschnitts an seinen beiden Enden an das Bezugspotential (M) angekoppelt ist.

3. Verstärker nach Anspruch 1, dadurch gekennzeichnet, daß jeder Hochfrequenzübertragungsleitungsabschnitt (36, 37, 45, 46) ein Mikrobandleitungsabschnitt ist, derart, daß das Metallband die Vorspannung zwischen seinen beiden Enden überträgt und die dem Metallband gegenüberliegende Metallisierungsebene an ihren beiden Enden an das Bezugspotential (M) angekoppelt ist.

4. Verstärker nach einem der vorhergehenden Ansprüche, dadurch gekennzeichnet, daß die Transistoren (T₃, T₄) bipolare Transistoren sind, die im AB-Betrieb arbeiten.

## Claims

1. Wideband high frequency power amplifier, organized around an earth circuit (M) serving as a reference potential, of the type including, in order from the input to the output, a first balanced transformer to the input of which a signal E to be amplified is injected, an input impedance converter, an amplifier stage including at least two transistors mounted in differential mode, an output impedance converter and a second balanced transformer delivering the amplified input signal S, characterized in that it furthermore includes at least one high frequency transmission line segment (36, 37, 45, 46) conveying each bias voltage respectively to the input electrode (B₃, B₄) and output electrode (C₃, C₄) of each transistor (T₃, T₄), having in parallel with each electrode (B₃, B₄) C₃, C₄) a high frequency impedance such that its effect is negligible with respect to the high frequency impedance presented by each electrode (B₃, B₄, C₃, C₄) of a transistor (T₃, T₄), and having a negligible series impedance in the baseband of the signal E to be amplified, such that the bias voltage applied to one of the ends of the line segment (36, 37, 45, 46) is conveyed substantially the same to its other end, connected to an electrode (B₃, B₄, C₃, C₄) of a transistor (T₃, T₄), and in that each line segment (36, 37) respectively sending the input bias voltage to each transistor (T₃, T₄) is of identical high frequency impedance and identical length, lying between a length of λ/8 and 3λ/8 where λ corresponds to the wavelength of the carrier of the signal E to be amplified, and in that each line segment (45, 46) respectively conveying the output bias voltage to each transistor (T₃, T₄) is of identical impedance and of identical length, lying between λ/8 and 3λ/8.

2. Amplifier according to Claim 1, characterized in that each high frequency transmission line segment (36, 37, 45, 46) is a coaxial line segment such that the inner conductor of the segment conveys the bias voltage between these two ends and such that the outer conductor of the segment is coupled at its two ends to the reference potential (M).

3. Amplifier according to Claim 1, characterized in that each high frequency transmission line segment (36, 37, 45, 46) is a microstrip line segment such that the metal strip conveys the bias voltage between its two ends and such that the metallized plane opposite the metal strip is coupled at its two ends to the reference potential (M).

4. Amplifier according to any one of the preceding claims, characterized in that the transistors (T₃, R₄) are bipolar transistors operating in class AB.
